# EUROPEAN PATENT SPECIFICATION

(11) **EP 1 497 102 B1**
(45) Date of publication and mention of the grant of the patent: **19.08.2009**
(21) Application number: 03723553.8
(22) Date of filing: 23.04.2003
(51) Int. Cl.: B29C 59/02, B81C 1/00, B82B 3/00, B41M 1/06

(54) **DEVICE AND METHOD FOR TRANSFERRING A PATTERN TO A SUBSTRATE**
VORRICHTUNG UND VERFAHREN ZUM ÜBERTRAGEN EINES MUSTERS AUF EIN SUBSTRAT
DISPOSITIF ET PROCEDE POUR TRANSFERER UNE STRUCTURE SUR UN SUBSTRAT

(30) Priority: 24.04.2002 SE 0201239; 24.04.2002 US 374827 P
(43) Date of publication of application: 19.01.2005
(73) Proprietor: Obducat AB, 201 25 Malmö (SE)
(72) Inventor: OLSSON, Lennart, S-216 21 Malmö (SE)
(74) Representative: Aurell, Henrik
(86) International application number: PCT/SE2003/000640
(87) International publication number: WO 2003/090985

(56) References cited:
- WO-A1-01/42858
- WO-A1-01/69317
- US-A- 5 772 905

## Description

### Technical Field of the Invention

The present invention relates to a device for transferring patterns, especially micro- or nanostructures, to at least two faces of a substrate.

The invention further relates to a method of transferring patterns, especially micro- or nanostructures, to at least two faces of a substrate and to a substrate having patterns on at least two faces thereof.

### Background Art

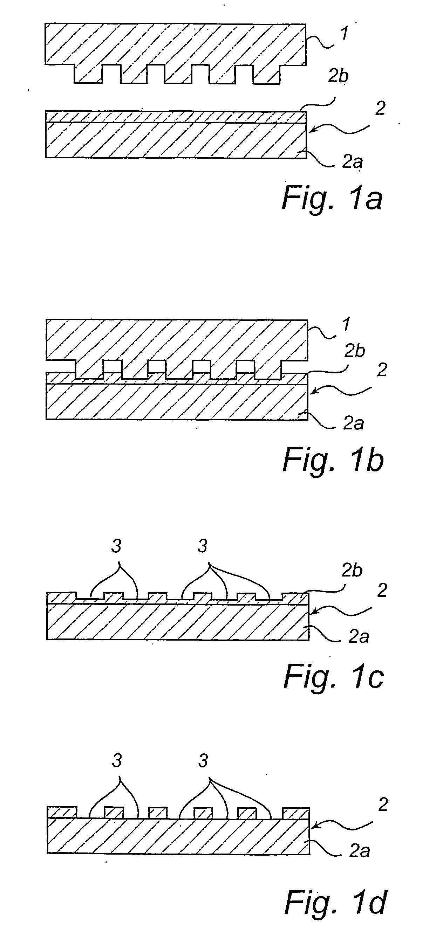

A technique for the reproduction of nanostructures, i.e. structures in the order of 1000 nm and smaller, is embossing imprint lithography. In this technique a stamp having a pattern is forced into contact with a substrate. The pattern is transferred to the substrate and the stamp is then removed from the substrate. An example of this method is shown in WO 01/69317. In such lithography, the main steps of which are schematically shown in Figs la-1d, a pattern of nanostructures is transferred from a stamp 1 to an object 2. The object 2 consists of a substrate 2a and, applied thereto, a film 2b of a polymer material (resist). After heating of the film 2b to a suitable temperature, the stamp 1 is pressed into the same (Fig 1b). The stamp 1 is then released from the object 2 when recesses 3 of a desired depth have been formed in the layer 2b (Fig 1c). Subsequently any remaining film in the recesses 3 is removed, for instance by etching, thereby exposing the substrate 2a (fig 1d). As alternative the object may be used directly after release of the stamp (fig 1c), without etching. In subsequent process steps (not shown), the pattern in the film may be reproduced in the substrate or in some other material, which is applied to the substrate. It is obvious to the skilled man that the above mentioned method with minor modifications may be used for forming patterns in solid or coated substrates, with or without heating and with or without subsequent etching.

WO 01/69317 further describes a device for transferring a pattern, particularly a pattern having micro- or nanostructures, from a stamp to an object. A pressing means is adapted to operate a contacting means for contacting the stamp with the object. The object is held by a holder which is pivotally attached to a base. The pivotally attached holder ensures that the stamp and the object are held in a mutually parallel relationship during stamping. After contacting the stamp is removed and the object, now having the pattern on its surface, can be removed from the holder.

In some applications it is of interest to form patterns, in particular patterns having micro- or nanostructures, on both sides of e.g. a flat plate like substrate. Using the device shown in WO 01/69317 the substrate having a first and a second flat side is first patterned on the first flat side. The substrate is then removed from the holder and put back with the patterned first flat side facing the holder and the not yet patterned second flat side facing the stamp, which may be the same as when patterning the first flat side or may have a different pattern.

A problem with the procedure described above is that the pattern of the first flat side may be damaged when contacting the stamp with the second flat side. The procedure as such is not very efficient since it requires the removal of the substrate between the two patterning steps. It is also difficult to obtain a very accurate alignment of the patterns of the first and second flat sides.

### Summary of the Invention

The object of the present invention is to provide a device for the efficient patterning of two sides of a substrate.

This object is achieved by a device according to claim 1. The stamping plates, being held together at their holding areas, will have a mutually fixed position allowing movement only in a direction perpendicular to the plane of the patterned areas. Thus the pattern formed on the first face of the substrate will have a well defined position in relation to the pattern formed on the second face of the substrate. It is also possible to form patterns on several substrates in mass production and being sure that the patterns of the first and second faces of the substrates always have the same position in relation to each other.

According to a preferred embodiment at least one of the stamping plates is elastically bendable in the direction of the other stamping plate. The elastically bendable stamping plate makes it possible to use elastic deformation when contacting the stamping plate with the substrate. After release of the force causing the contact between the substrate and the stamping plate the stamping plate will retract to exactly its original position. The problems that could be associated with e.g. play in joints are thus avoided and the reproducibility is enhanced. According to a still more preferred embodiment both stamping plates are elastically bendable towards each other. The stamping plates may thus be contacted with the respective first and second faces of the substrate and after that be retracted to exactly their original positions.

Preferably a holding means for holding the stamping plates firmly together comprises a spacer which is located between the two stamping plates for holding them at a distance from each other. The spacer makes it easier to insert the substrate between the patterned areas. When patterning thick substrates and using elastically bendable stamping plates a spacer is required to avoid bending the stamping plates too much. A large bending of the stamping plates may result in the deformation of the plates and the obstruction of the pattern. According to a still more preferred embodiment the thickness of the spacer is substantially the same as the thickness of the substrate. When simultaneously contacting the substrate with both stamping plates the stamping plates will be next to parallel with each other. This gives the best reproduction of the pattern on the substrate.

Preferably the contacting means comprises at least one chamber being adapted to cooperate with one of the stamping plates at the face of said plate facing away from said substrate and to provide a compressive force by means of fluid pressure acting on the stamping plate for contacting it with the substrate. Fluid pressure is advantageous in generating the compressive force since it provides a very even pressure over the surface of the stamping plate. Thus the force with which the stamping plate acts on the substrate will be very even over the whole of the patterned area. This is particularly important when forming structures in the nanometer scale since any difference in contacting force over the area may obstruct the pattern.

According to another preferred embodiment the contacting means comprises a first chamber being adapted to cooperate with the first stamping plate at the face of said first plate facing away from said substrate and to provide a compressive force by means of fluid pressure acting on the first stamping plate for contacting it with the first face of the substrate, and a second chamber being adapted to cooperate with the second stamping plate at the face of said second plate facing away from said substrate and to provide a compressive force by means of fluid pressure acting on the second stamping plate for contacting it with the second face of the substrate simultaneously with the first stamping plate contacting the first face of the substrate. The two chambers provide an even pressure on both stamping plates thus ensuring an even contacting force on both faces of the substrate. A further advantage is that both chambers may be connected to a common source of pressurized fluid. The same force will then act simultaneously on both stamping plates thus ensuring the simultaneous contacting with the same force of both stamping plates.

Preferably each chamber is provided with means for providing a suction force within the chamber such that the stamping plate, cooperating therewith, by means of suction force is moved away from said substrate after having formed a pattern thereon. During the forming of a pattern a certain adhesion of the patterned area to the substrate may occur. The suction force makes it possible to gently separate the stamping plate from the substrate after the patterning step without having to interfere with mechanical means, such as a pair of tweezers, which may damage the substrate and/or the patterned areas.

Preferably at least one of the stamping plates comprises a fluid channel adapted to be connected to a fluid supply means for supplying fluid to said channel, and at least one nozzle connected to said fluid channel and adapted to eject said fluid in the direction of the substrate in order to facilitate removal of the substrate from the device after said forming of a pattern. In some cases the substrate may not easily be released from the patterned area after the contacting therewith. It may also be that, although using the above described suction force, the substrate still adheres to at least one of the stamping plates. The means for supplying a flow of fluid in the direction of the substrate forces, in a gentle manner, the substrate to release from the stamping plate. If the fluid is air, or another gas, which is supplied to both stamping plates, an air cushion may be formed making the substrate "float" out of the stamping plates with minimum risk of damage to substrate and patterned areas. The flow of fluid, e.g. the air cushion, also facilitates the insertion of a new substrate in the device.

Preferably the patterned area of at least one of the stamping plates is formed on a separate mould being detachably fixed to at least one stamping plate. This makes it quicker to change the pattern of the stamping plate since only the patterned area, i.e. the mould, and not the whole stamping plate needs to be exchanged. A further advantage is that the mould can be made of materials that are suitable for forming patterns but may not be suitable for manufacturing stamping plates. In some cases an adjustment of the holding means is required after such a change to ascertain that the pattern of the first and second stamping plates are still properly aligned.

A further object of the present invention is to provide an efficient method of patterning of two sides of a substrate.

This object if achieved by a method according to claim 11. This method is advantageous since it makes it possible to mass produce substrates having patterns on two faces, said patterns having a very accurate position in relation to each other.

According to a preferred embodiment of the method according to the invention the step of contacting the substrate with the first and the second patterned areas further comprises providing a fluid pressure on at least one of the stamping plates at the face of said stamping plate facing away from said substrate. Providing fluid pressure results in a very even force being applied over the area of the stamping plate.

A still further object of the invention is to provide a substrate having patterns on at least two faces thereof, the patterns being aligned with each other. This object is achieved with a substrate according to claim 14.

### Brief Description of the Drawings

The invention will be further described with reference to preferred embodiments and the enclosed drawings.

Fig 1a-1d illustrate transfer of a pattern from a stamp to a substrate by nanoimprint lithography according to a known process (as described above).

Fig 2 is a sectional view and shows schematically a first embodiment of the device according to the invention.

Fig 3 is an enlarged sectional view of a part of a chamber and stamping plates shown in figure 2.

Fig 4a is a sectional view and shows an enlargement of a spacer shown in figure 2.

Fig 4b is a sectional view and shows an alternative embodiment of a spacer.

Fig 5 is an exploded sectional view and shows a part of the device of figure 2.

Fig 6 is a sectional view and shows stamping plates in an alternative embodiment.

Fig 7 is a plan view of a further alternative embodiment of the invention.

### Detailed Description of Preferred embodiments of the Invention

The present invention relates to nano imprinting, i.e. the forming of patterns in substrates by forcing a stamp having a pattern into contact with a substrate thereby transferring said pattern to the substrate. Examples of products that could be manufactured with the aid of the present invention include hard disks, optical disk, micromechanical devices, microfluid devices and microelectronic devices.

The term "nano-imprinting" should not be read as referring only to submicron structures, i.e. structures with a size in the range of 0,1-1000 nm. A pattern often includes both submicron structures and structures with a size of up to 100 micron, and larger. The present invention is applicable for forming of patterns comprising submicron structures and/or micron structures. The invention is particularly advantageous when forming patterns comprising submicron structures since these are relatively more sensitive to incorrect positioning of the transferred patterns relative to each other.

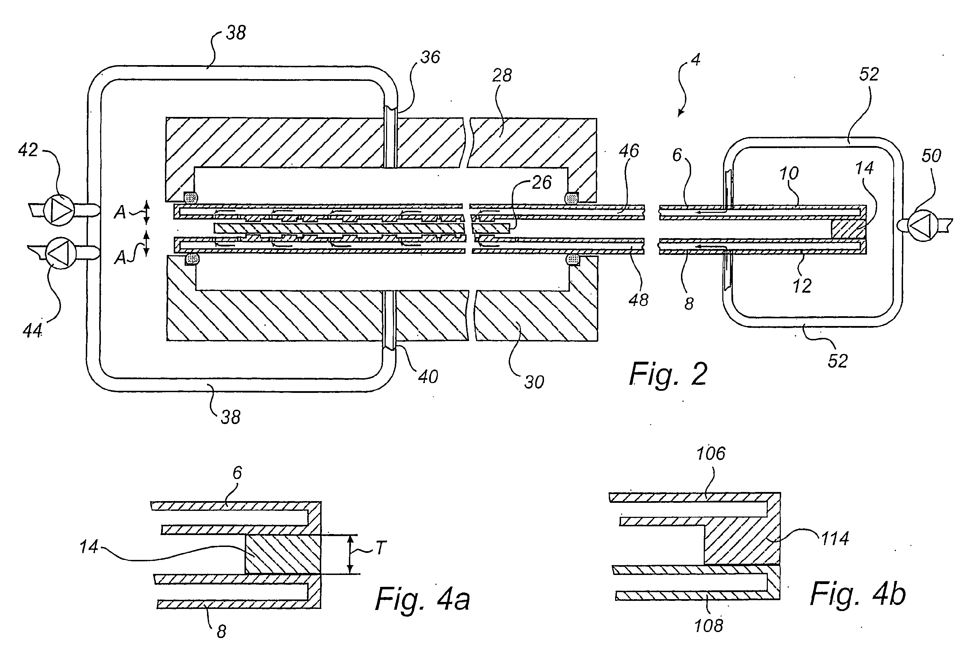

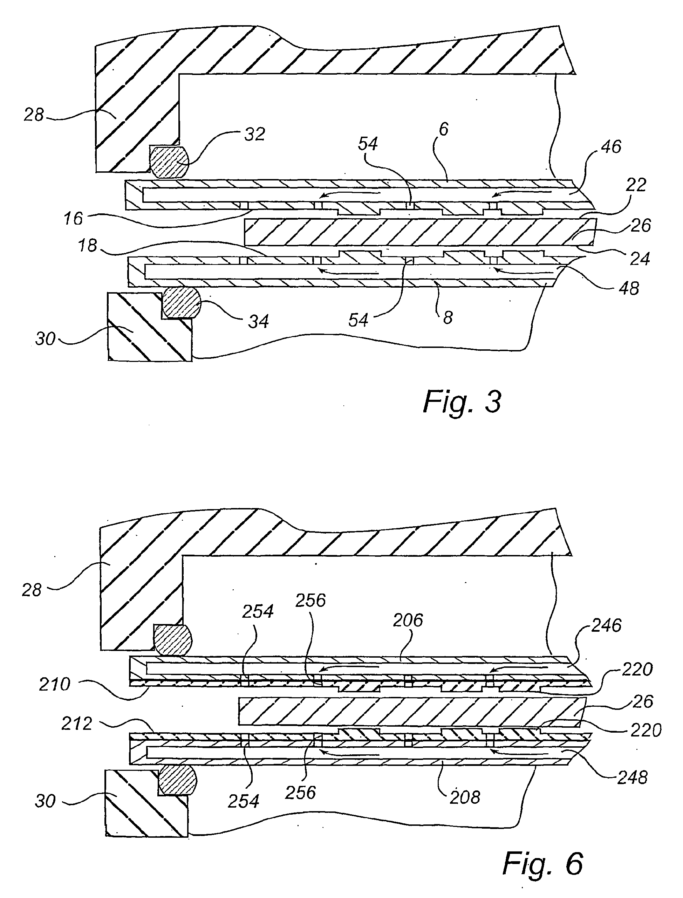

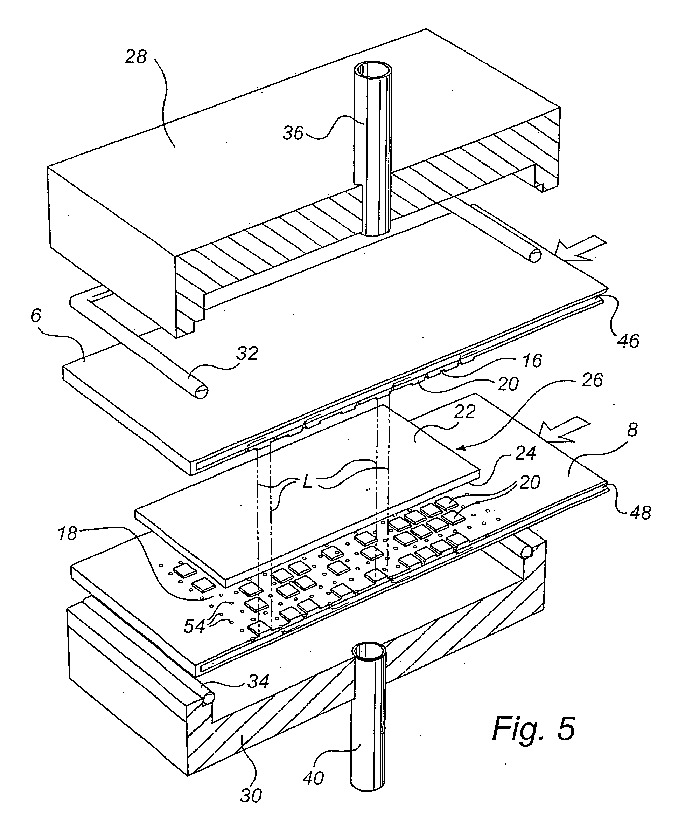

In figure 2 a device 4 according to the invention is shown. The device 4 has a first stamping plate 6 and a second stamping plate 8. The stamping plates 6, 8 are .substantially flat plates having such a width that they are substantially rigid in the plane of the plates. The thickness of the stamping plates 6, 8 is such that they can be elastically bent in a direction normal to said plane as indicated by arrows A in figure 2. The stamping plates 6, 8 are held together at holding areas 10, 12 located at first ends thereof by a holding means in the form of a spacer 14. The spacer 14 is fixed to each of the stamping plates 6, 8 thus holding them in a fixed relation to each other. At a second end, being located at the opposite end of the respective stamping plate 6, 8 and at a distance from the holding area 10, 12, each stamping plate has a patterned area 16, 18, as shown in figs 3 and 5.

As schematically shown in figure 5 each patterned area 16, 18 has a number of protrusions 20 which may be forced into a first face 22 and a second face 24 of a substrate 26 according to the same principles as discussed in relation to figure 1a-d. The lines denoted L in figure 5 indicate that patterned areas 16 and 18 are carefully aligned, i.e. are in register with each other, such that the protrusions 20 of the first patterned area 16 exactly match the corresponding protrusions 20 of the second patterned area 18.

The device 4 further comprises a contacting means in the form of a first chamber 28 and a second chamber 30. The first chamber 28 is sealed to the first stamping plate 6 by means of a gasket 32 as can be seen from fig 3. The second chamber 30 is sealed to the second stamping plate 8 by means of a gasket 34. The first chamber 28 has a connection 36 to a gas conduit 38 and the second chamber 30 has a connection 40 to the same gas conduit 38.

A pressure means in the form of a compressor 42 is arranged to provide pressurized air to the gas conduit 38 and thus to the chambers 28, 30. A suction means in the form of a vacuum pump 44 is arranged to provide under pressure in the gas conduit 38 and thus to the chambers 28, 30. Since the gas conduit 38 is common for both chambers 28, 30 the same under- or overpressure will be supplied to both chambers 28, 30 simultaneously. Thus the same force will act simultaneously on the stamping plates 6, 8.

Each stamping plate 6, 8 is further provided with a fluid channel 46, 48. A fluid supply means in the form of a compressor 50 is arranged to supply pressurized air via an air conduit 52 to the fluid channels 46, 48. As indicated by arrows in figure 2 and 3 the air will be forwarded by the respective fluid channels 46, 48 to nozzles in the form of circular holes 54 located in the patterned areas 16, 18.

The spacer 14 has, as indicated in figure 4a, a thickness T, which is substantially the same as the thickness of the substrate. As an example, the thickness of a hard disk is about 0,3 mm and thus the thickness T of the spacer 14 should also be about 0,3 mm when forming patterns on hard disks.

In figure 4b an alternative embodiment of a holding means is shown. In this embodiment a first stamping plate 106 has a holding means comprising a projection 114. The projection 114 is glued to a second stamping plate 108 to hold the two stamping plates 106, 108 in a fixed relation to each other.

Figure 6 shows stamping plates according to another embodiment of the invention. A first stamping plate 206 has a mould 210 attached to it. A second stamping plate 208 has a mould 212 attached to it. Each of the moulds 210, 212 has a number of protrusions 220 formed on their respective surfaces for contacting the substrate 26 according to the principles described in figs 1a-1d. The moulds 210, 212 thus serve as patterned areas. The use of moulds 210, 212 has the advantage that the pattern to be transferred to the substrate 26 may be changed without having to exchange the entire stamping plate 206, 208. The moulds 210, 212 are made from a material suitable for forming nano- and or microstructured patterns. Examples of such materials are silicon, nickel and chromium. The stamping plates 206, 208 may be manufactured from easily machinable metals, such as aluminum and stainless steel. Thus, also when the moulds are not detachable, the mould provide the advantage of a broader selection of materials for the patterned area. The forming of a pattern on the mould 210, 212 could be made either before or after fixing it to the stamping plate 206, 208. The mould 210, 212 could be fixed to the stamping plate 206, 208 by e.g. clamping or gluing.

The stamping plates 206, 208 have fluid channels 246, 248 of similar design as those described with reference to figure 3. The fluid channels are connected to holes 254 in the stamping plates 206, 208. The moulds 210, 212 have corresponding holes 256 so that fluid forwarded by the fluid channels 246, 248 may be ejected towards the substrate 26 via the holes 254 and 256.

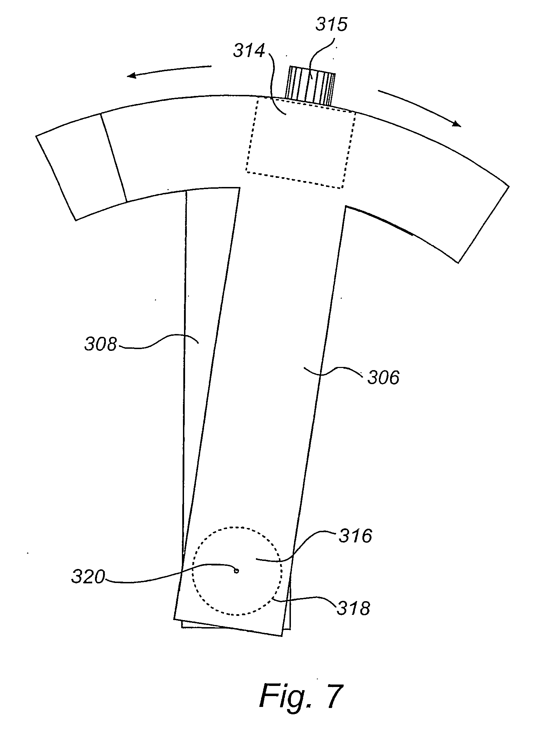

In figure 7 a first stamping plate 306 and a second stamping plate 308 according to another embodiment of the invention are shown. The stamping plates 306, 308 are "T"-shaped with their top parts being arched. Each stamping plate 306, 308 has at its second end a circular patterned area 316, 318 (below 316 in fig 7) that face each other and are adjusted to have a common symmetry axis 320. A holding means comprises a spacer 314 located at the first ends, being located at a distance from the patterned areas 316, 318, of the stamping plates 306, 308 for holding them at a well defined distance from each other. The holding means also has an adjustment screw 315 which is connected to a rack and pinion (not shown) and makes it possible to adjust the position of the patterned area 316 in relation to the patterned area 318 by rotating the patterned area 316 while maintaining the common symmetry axis 320 and keeping the distance constant between the two areas 316, 318. As indicated by the arrows in figure 7 the first stamping plate 306 will show an arched movement, with the arch having a centre coinciding with the symmetry axis 320, in relation to the second stamping plate 308 when the adjustment screw 315 is turned. This embodiment is advantageous when patterning circular substrates, such as hard disks, where the patterns on the first and the second faces of the substrate must have the same symmetry axis and have a certain rotational position in relation to each other.

The operation of the device 4 will now be described with reference to the drawings. Firstly the desired pattern is formed on the patterned areas 16, 18 of the stamping plates 6, 8. The pattern forming may be made using one of the methods known in the art, such as UV radiation of a photosensitive film followed by etching, electron beam radiation or particle beam radiation.

The patterned areas 16, 18 are turned to face each other and a spacer 14 is placed between the stamping plates 6, 8. The relative position of the stamping plates 6, 8 could either be checked and adjusted by observing the patterned areas 16, 18 in a microscope or tests could be made by contacting several substrates 26, analyzing them and subsequently adjusting the position of the patterned areas 16, 18 relatively to each other. When the patterned areas 16, 18 have the correct position relatively to each other they are fixed to the spacer 14. This could e.g. be made by gluing them to the spacer 14 or by fixing a clamp (not shown) pressing the stamping plates 6, 8 towards the spacer 14. After the stamping plates 6, 8 have been fixed to the spacer 14 no further adjustments will be necessary and many substrates 26 can be processed with high accuracy.

The chambers 28, 30 are then sealed to the stamping plates 6 and 8 respectively and a substrate 26 is put between the stamping plates 6, 8 at the patterned areas 16, 18. The compressor 42 is started and pressurized air is provided to the chambers 28 and 30 via the gas conduit 38. The pressure makes the stamping plates 6, 8 bend elastically towards the substrate 26 and thus the protrusions 20 contact and penetrate into the first and second faces 22, 24 of the substrate 26. When the patterns of the patterned areas 16, 18 have been transferred to the substrate 26, the compressor 42 is shut off, the pressure in the chambers 28, 30 is released and the stamping plates 6, 8 elastically retracts from the substrate 26. To further increase the retraction the vacuum pump 44 may be operated to provide a slight under pressure to the chambers 28, 30 thus forcing the stamping plates 6, 8 to elastically bend away from the substrate.

The compressor 50 is then started. A flow of air is thereby ejected through the holes 54 and forms an air cushion between the substrate 26 and the respective patterned areas 16, 18. The substrate may then be taken out of the device quite easily and with little risk of damaging the structures on the substrate 26 and/or on the patterned areas 16, 18. A new substrate 26 may then be inserted, preferably with the compressor 50 and thus the air cushion still in action, into the device 4 and the procedure is then repeated.

It will be appreciated that numerous modifications of the embodiments described above are possible within the scope of the appended claims.

Thus the width of spacer 14 could be varied to fit the individual case. It is often preferable to use a spacer 14 having substantially the same thickness T, see figure 4a, as the substrate 26 since this will result in minimum elastic deflection of the stamping plates 6, 8 during contact. It is, at lest with very thin substrates, also possible to fit the stamping plates directly to each other at the holding area. Since the holding area is located at a distance from the patterned area the deflection will be quite small with such thin substrates.

The alignment of the two stamping plates is preferably an iterative process where tests with contacting substrates are performed. The test substrate is analysed, e.g. with a microscope. If adjustments are required e.g. a clamp fixing the stamping plates to the spacer is loosened such that the stamping plates could be moved slightly in relation to each other. The clamp is then secured again and a new test contacting is performed. The procedure is repeated until the test substrate shows that the two stamping plates have the proper alignment relative to each other.

The contacting means could be of many different types. In addition to pressure chambers also mechanical means including step motors, hydraulic cylinders etc could be used for forcing the stamping plates towards the substrate. It is often preferable to contact both faces of the substrate simultaneously and with the same force. The use of two pressure chambers being connected to a common pressure source and each acting on a stamping plate makes this rather easy. A clamp or a similar tool acting simultaneously on both stamping plates to force them towards the substrate may also be used.

The fluid supplied to the pressure chambers 28, 30 could be air, nitrogen, water, hydraulic oil or another suitable gas or liquid. Due to the easy handling pressurized air is often preferred.

The fluid supplied to the fluid channels 46, 48 may be any of the above mentioned gases or liquids. The holes 54 often have a very small diameter, such as 0,1 mm - 0,001 mm, and thus the fluid must be very clean. Also the fluid must not cause damage or chemical attack to the patterns on the faces of the substrate. Preferable fluids are clean air and clean nitrogen gas.

The invention is very suitable for forming patterns in two opposite flat sides of flat substrates. The two patterned areas 16 and 18 may have exactly the same pattern or may have patterns being mirror images of each other. The two patterned areas 16, 18 may also have different patterns. In all cases the invention is advantageous if the patterns must be aligned, i.e. formed in a well defined position in relation to each other, on two faces of a substrate. The patterned areas could be divided in sub areas to form several objects, such as several microelectronic devices, on one substrate.

Preferably the stamping plates and the patterned areas are elastically bendable in the direction of the substrate. It is also possible to use patterned moulds that are relatively stiff and attach them to elastically bendable stamping plates. It is also possible to form composite stamping plates. One such example is a stamping plate of steel having a surface of nickel in the area intended for the patterned area. The substrates are preferably elastically bendable. It is also possible to use rigid substrates.

The fluid channels in the stamping plates could also be used to fix the substrate to at least one of the patterned areas before the forming of a pattern. In such a case a fresh substrate is placed between the stamping plates and then a suction is provided via the fluid channels 46, 48 and thus via the holes 54 (a vacuum pump, not shown, is connected to the conduit 52). The fresh substrate is thus fixed to the stamping plate/-s by suction. After forming the pattern a pressure is provided to the fluid channels 46, 48 to facilitate removal of the patterned substrate.

The stamping plates may be formed without fluid channels. In such a case the stamping plates may be solid and made of a thin metal sheet. The stamping plates could also be provided with two holding areas each. In such a case the patterned area of each stamping plate is located at the centre of the stamping plate and the holding areas are located at two opposite ends of the stamping plate each at a distance from the patterned area. The stamping plates are joined to each other at two locations, i.e. the two holding areas, via spacers located at each of the two holding areas. This embodiment makes the stiffness in the plane of the plates.of the stamping plates even larger. Also the risk of the stamping plates getting out of position during contacting substrates is further decreased. The stamping plates may be attached to each other at still more holding areas. Thus the stamping plates are fixedly attached to each other at least at one position (as shown in fig 2), but could as alternative be attached to each other at 2, 3 or more positions.

The invention has particular advantages when forming patterns having nano- and/or microstructures. The invention is still more preferable when forming patterns comprising structures, such as lines and protruding parts, having widths or critical dimensions in the range of 500 nm and smaller.

## Claims

1. A device for transferring patterns, especially micro- or nanostructures, to at least two faces of a substrate (26), the device (4) comprising
a first stamping plate (6; 206; 306) having a patterned area (16; 210; 316) provided thereon for forming a first pattern on a first face (22) of said substrate (26),
a second stamping plate (8; 208; 308) having a patterned area (18; 212; 318) provided thereon for forming a second pattern on a second face (24) of said substrate (26), and
a contacting means (28, 30) for contacting the respective patterned areas (16, 18; 210, 212; 316, 318) of the two stamping plates with the respective faces (22, 24) of said substrate (26),
the first and the second stamping plates (6, 8; 206, 208; 306, 308) being aligned with each other and being secure to each other at respective holding areas 10, 12) of the stamping plates (6, 8; 206, 208; 306, 308) located at a distance from the patterned areas (16, 18; 210, 212; 316, 318), such that the patterned areas face each other.

2. A device according to claim 1, wherein at least one of the stamping plates (6; 206; 306) is elastically bendable in the direction of the other stamping plate (8; 208; 308).

3. A device according to claim 1 or 2, wherein both stamping plates (6, 8; 206, 208; 306, 308) are elastically bendable towards each other.

4. A device according to any one of the preceding claims, wherein a holding means for holding the stamping plates firmly together comprises a spacer (14; 114; 314) which is located between the two stamping plates (6, 8; 106, 108; 306, 308) for holding them at a distance from each other.

5. A device according to claim 4, wherein the thickness (T) of the spacer (14; 114; 314) is substantially the same as the thickness of the substrate (26).

6. A device according to any one of the preceding claims, wherein the contacting means comprises at least one chamber (28, 30) being adapted to cooperate with one of the stamping plates (6, 8; 206, 208) at the face of said plate (6, 8; 206, 208) facing away from said substrate (26) and to provide a compressive force by means of fluid pressure acting on the stamping plate (6, 8; 206, 208) for contacting it with the substrate (26).

7. A device according to any one of claims 1-5, wherein the contacting means (28, 30, 36, 38, 40, 42) comprises
a first chamber (28) being adapted to cooperate with the first stamping plate (6; 206) at the face of said first plate (6; 206) facing away from said substrate (26) and to provide a compressive force by means of fluid pressure acting on the first stamping plate (6; 206) for contacting it with the first face (22) of the substrate (26), and
a second chamber (30) being adapted to cooperate with the second stamping plate (8; 208) at the face of said second plate (8; 208) facing away from said substrate (26) and to provide a compressive force by means of fluid pressure acting on the second stamping plate (8; 208) for contacting it with the second face (24) of the substrate (26) simultaneously with the first stamping plate (6; 206) contacting the first face (22) of the substrate (26).

8. A device according to claim 6 or 7, wherein each chamber (28, 30) is provided with means (44) for providing a suction force within the chamber (28, 30) such that the stamping plate (6, 8; 206, 208), cooperating therewith, by means of suction force is moved away from said substrate (26) after having formed a pattern thereon.

9. A device according to any one of the preceding claims wherein at least one of the stamping plates (6, 8; 206; 208) comprises
a fluid channel (46, 48; 246; 248) adapted to be connected to a fluid supply means (50, 52) for supplying fluid to said channel (46, 48; 246; 248), and
at least one nozzle (54; 254) connected to said fluid channel (46, 48; 246; 248) and adapted to eject said fluid in the direction of the substrate (26) in order to facilitate removal of the substrate (26) from the device (4) after said forming of a pattern.

10. A device according to any one of the preceding claims, wherein the patterned area of at least one of the stamping plates (206, 208) is formed on a separate mould (210, 212) being detachably fixed to at least one stamping plate (206, 208).

11. A method of transferring patterns, especially micro- or nanostructures, to at least two faces (22, 24) of a substrate (26), the method comprising the steps of
providing a first patterned area (16; 210; 316) on a first stamping plate (6; 206; 306),
providing a second patterned area (18; 212; 318) on a second stamping plate (8; 208; 308),
positioning the two stamping plates (6, 8; 206, 208; 306, 308) such that the patterned areas (16, 18; 210, 212; 316, 318) face each other,
securing the two stamping plates (6, 8; 206, 208; 306, 308) to each other at a position (10, 12) thereon located at a distance from said patterned areas (16, 18; 210, 212; 316, 318),
placing a substrate (26) between the patterned areas (16, 18; 210, 212; 316, 318), and
contacting the substrate (26) with the first (16; 210; 316) and the second patterned areas (18; 212; 318)

12. A method according to claim 11, wherein the step of contacting the substrate (26) with the first (16; 210; 316) and the second patterned areas (18; 212; 318) further comprises providing a fluid pressure on at least one of the stamping plates .(6, 8; 206, 208; 306, 308) at the face of said stamping plate (6, 8; 206, 208; 306, 308) facing away from said substrate (26).

13. A method according to claim 11 or 12, further comprising the step of directing a flow of fluid from openings (54; 254, 256) in the stamping plates (6, 8; 206, 208; 306, 308) towards the substrate (26) to facilitate removal of said substrate (26) after transferring the pattern.

## Patentansprüche

1. Vorrichtung zum Übertragen von Mustern, insbesondere Mikro- oder Nanostrukturen, auf zumindest zwei Flächen eines Substrats (26), wobei die Vorrichtung (4) umfasst
eine erste Stanzplatte (6; 206; 306) mit einem darauf vorgesehenen gemusterten Bereich (16; 210; 316) zum Auszubilden eines ersten Musters auf einer ersten Fläche (22) des Substrats (26);
eine zweite Stanzplatte (8; 208; 308) mit einem darauf vorgesehenen gemusterten Bereich (18; 212; 318) zum Auszubilden eines zweiten Muster auf einer zweiten Fläche (24) des Substrats (26);
ein Kontaktierungselement (28, 30) zum Kontaktieren des jeweiligen gemusterten Bereichs (16, 18; 210, 212; 316, 318) der zwei Stanzplatten mit den jeweiligen Flächen (22, 24) des Substrats (26),
wobei die erste und die zweite Stanzplatte (6, 8; 206, 208; 306, 308) miteinander fluchten und an jeweiligen Haltebreichen (10, 12) der Stanzplatten (6, 8; 206, 208; 306, 308), die mit einem Abstand von den gemusterten Bereichen (16, 18; 210, 212; 316, 318) angeordnet sind, aneinander befestigt sind, so dass die gemusterten Bereiche sich gegenüberliegen.

2. Vorrichtung nach Anspruch 1, bei der zumindest eine der Stanzplatten (6; 206; 306) elastisch in Richtung der anderen Stanzplatte (8; 208; 308) biegbar ist.

3. Vorrichtung nach Anspruch 1 oder 2, bei der beide Stanzplatten (6, 8; 206, 208; 306, 308) elastisch in Richtung der jeweils anderen biegbar sind.

4. Vorrichtung nach einem der vorhergehenden Ansprüche, bei der eine Haltevorrichtung zum festen Zusammenhalten der Stanzplatten einen Abstandshalter (14; 114; 314) umfasst, welcher zwischen den beiden Stanzplatten (6, 8; 206, 208; 306, 308) angeordnet ist um diese voneinander beabstandet zu halten.

5. Vorrichtung nach Anspruch 4, bei der die Dicke (T) des Abstandshalters (14; 114; 314) im Wesentlichen gleich der Dicke des Substrates (26) ist.

6. Vorrichtung nach einem der vorhergehenden Ansprüche, bei der das Kontaktierungselement zumindest eine Kammer (28, 30) umfasst, die dazu ausgebildet ist mit einer der Stanzplatten (6, 8; 206, 208) an der von dem Substrat (26) wegzeigenden Fläche der Stanzplatte (6, 8; 206, 208) zusammenzuwirken, und die dazu ausgebildet ist eine Kompressionskraft mittels einem auf die Stanzplatte (6, 8; 206, 208) wirkenden Fluiddruck, um diese mit dem Substrat (26) zu kontaktieren, vorzusehen.

7. Vorrichtung nach einem der Ansprüche 1 bis 5, bei der das Kontaktierungselement (28, 30, 36, 38, 40, 42) umfasst:
eine erste Kammer (28), die ausgebildet ist, um mit der ersten Stanzplatte (6; 206) auf der Fläche der ersten Stanzplatte (6; 206) die von dem Substrat (26) weg zeigt zusammenzuwirken und die dazu ausgebildet ist eine Kompressionskraft mittels Fluiddruck, der auf die erste Stanzplatte (6; 206) wirkt, um diese mit der ersten Fläche (22) des Substrats (26) zu kontaktieren, vorzusehen und
eine zweite Kammer (30), die ausgebildet ist, um mit der zweiten Stanzplatte (8; 208) auf der Fläche der zweiten Stanzplatte (8; 208) die von dem Substrat (26) weg zeigt zusammenzuwirken und die dazu ausgebildet ist eine Kompressionskraft mittels Fluiddruck, der auf die zweite Stanzplatte (8; 208) wirkt, um diese zeitgleich mit der ersten Stanzplatte (6; 206), die die erste Fläche (22) des Substrats (26) kontaktiert, und der zweiten Fläche (24) des Substrats (26) zu kontaktieren, vorzusehen.

8. Vorrichtung nach Anspruch 6 oder 7, bei der jede Kammer (28, 30) mit Mitteln (44) zum Vorsehen einer Saugkraft innerhalb der Kammer (28, 30) versehen ist, so dass die damit kooperierende Stanzplatte (6, 8; 206, 208) mittels Saugkraft nachdem ein Muster darauf ausgeformt wurde weg von dem Substrat (26) bewegt wird.

9. Vorrichtung nach einem der vorhergehenden Ansprüche, bei der zumindest eine der Stanzplatten (6, 8; 206, 208) umfasst
einen Fluidkanal (46, 48; 246, 248), der angepasst ist, um mit einer Fluidversorgungseinrichtung (50, 52) verbunden zu werden, um den Kanal (46, 48; 246, 248) mit Fluid zu versorgen, und
zumindest eine Düse (54; 254) die mit dem Fluidkanal (46, 48; 246, 248) verbunden ist und ausgebildet ist, um das Fluid in die Richtung des Substrats (26) auszugeben, um die Entfernung des Substrats (26) aus der Vorrichtung (4) nach dem Ausbilden eines Musters zu erleichtern.

10. Vorrichtung nach einem der vorhergehenden Ansprüche, bei der der gemusterte Bereich zumindest einer der Stanzplatten (206, 208) als separate Form (210, 212), die abnehmbar an zumindest einer Stanzplatte (206, 208) fixiert ist, ausgeformt ist.

11. Verfahren zum Übertragen von Mustern, insbesondere Mikro- oder Nanostrukturen, auf zumindest zwei Flächen eines Substrats (26), wobei das Verfahren die Schritt umfasst
Vorsehen eines ersten gemusterten Bereichs (16; 210; 316) auf einer ersten Stanzplatte (6; 206; 306)
Vorsehen eines zweiten gemusterten Bereichs (18; 212; 318) auf einer zweiten Stanzplatte (8; 208; 308)
Positionieren der beiden Stanzplatten (6, 8; 206, 208; 306, 308), so dass die gemusterten Bereiche (16, 18; 210, 212; 316, 318) einander zugewandt sind,
Aneinandersichern der beiden Stanzplatten (6, 8; 206, 208; 306, 308) an einem auf ihnen vorgesehenen Ort, der beabstandet von den gemusterten Bereichen (16, 18; 210, 212; 316, 318) angeordnet ist,
Anordnen eines Substrats (26) zwischen den gemusterten Bereichen (16, 18; 210, 212; 316, 318), und
Verbinden des Substrats (26) mit dem ersten (16; 210; 316) und dem zweiten (18; 212; 318) gemusterten Bereich.

12. Verfahren nach Anspruch 11, bei dem der Schritt des Kontaktierens des Substrats (26) mit dem ersten (16; 210; 316) und dem zweiten (18; 212; 318) gemusterten Bereich ferner das Vorsehen eines Fluiddrucks auf zumindest einer der Stanzplatten (6, 8; 206, 208; 306, 308) auf der Fläche der Stanzplatte (6, 8; 206, 208; 306, 308), die von dem Substrat (26) weg zeigt, umfasst.

13. Verfahren nach Anspruch 11 oder 12 ferner aufweisend den Schritt des Richtens eines Fluidflusses von Öffnungen (54; 254, 256) der Stanzplatten (6, 8; 206, 208; 306, 308) in Richtung des Substrats (26), um das Entfernen des Substrats nach dem Übertragen des Musters zu erleichtern.

## Revendications

1. Dispositif pour transférer des motifs, en particulier des micro et nanostructures, à au moins deux faces d'un substrat (26), le dispositif (4) comprenant
une première plaque d'impression (6 ; 206 ; 306) ayant une région imprimée (16 ; 210 ; 316) prévue sur celle-ci pour former un premier motif sur une première face (22) dudit substrat (26),
une deuxième plaque d'impression (8 ; 208 ; 308) ayant une région imprimée (18 ; 212 ; 318) prévue sur celle-ci pour former un deuxième motif sur une deuxième face (24) dudit substrat (26), et
un moyen de mise en contact (28, 30) pour mettre en contact et les régions imprimées respectives (16, 18 ; 210, 212 ; 316, 318) des deux plaques d'impression avec les faces respectives (22, 24) dudit substrat (26),
les première et deuxième plaques d'impression (6, 8 ; 206, 208 ; 306, 308) étant alignées l'une par rapport à l'autre et étant fixées l'une à l'autre à des régions de support respectives (10, 12) des plaques d'impression (6, 8 ; 206, 208 ; 306, 308) situées à une distance des régions imprimées (16, 18 ; 210, 212 ; 316, 318), de sorte que les régions imprimées soient en face l'une de l'autre.

2. Dispositif selon la revendication 1, dans lequel au moins l'une des plaques d'impression (6 ; 206 ; 306) peut être courbée de manière élastique dans la direction de l'autre plaque d'impression (8 ; 208 ; 308).

3. Dispositif selon la revendication 1 ou 2, dans lequel les deux plaques d'impression (6, 8 ; 206, 208 ; 306, 308) peuvent être courbées de manière élastique l'une vers l'autre.

4. Dispositif selon l'une quelconque des revendications précédentes, dans lequel un moyen de support pour maintenir solidement les plaques d'impression ensemble comprend un espaceur (14 ; 114 ; 314) qui est situé entre les deux plaques d'impression (6, 8 ; 106, 108 ; 306, 308) pour les maintenir à une distance l'une de l'autre.

5. Dispositif selon la revendication 4, dans lequel l'épaisseur (T) de l'espaceur (14 ; 114 ; 314) est sensiblement la même que l'épaisseur du substrat (26).

6. Dispositif selon l'une quelconque des revendications précédentes, dans lequel le moyen de mise en contact comprend au moins une chambre (28, 30) adaptée pour coopérer avec l'une des plaques d'impression (6, 8 ; 206, 208) à la face de ladite plaque (6, 8 ; 206, 208) à l'opposé dudit substrat (26) et pour fournir une force de compression au moyen d'une pression fluidique agissant sur la plaque d'impression (6, 8 ; 206, 208) pour la mettre en contact avec le substrat (26).

7. Dispositif selon l'une quelconque des revendications 1 à 5, dans lequel le moyen de mise en contact (28, 30, 36, 38, 40, 42) comprend
une première chambre (28) adaptée pour coopérer avec la première plaque d'impression (6 ; 206) à la face de ladite première plaque (6 ; 206) à l'opposé dudit substrat (26) et pour fournir une force de compression au moyen d'une pression fluidique agissant sur la première plaque d'impression (6 ; 206) pour la mettre en contact avec la première face (22) du substrat (26), et
une deuxième chambre (30) adaptée pour coopérer avec la deuxième plaque d'impression (8 ; 208) à la face de la deuxième plaque (8 ; 208) à l'opposé dudit substrat (26) et pour fournir une force de compression au moyen d'une pression fluidique agissant sur la deuxième plaque d'impression (8 ; 208) pour la mettre en contact avec la deuxième face (24) du substrat (26) simultanément avec la première plaque d'impression (6 ; 206) entrant en contact avec la première face (22) du substrat (26).

8. Dispositif selon la revendication 6 ou 7, dans lequel chaque chambre (28, 30) est munie de moyens (44) pour fournir une force d'aspiration dans la chambre (28, 30) de sorte que la plaque d'impression (6, 8 ; 206, 208), coopérant avec celle-ci, au moyen d'une force d'aspiration soit éloignée dudit substrat (26) après avoir formé un motif dessus.

9. Dispositif selon l'une quelconque des revendications précédentes, dans lequel au moins l'une des plaques d'impression (6, 8 ; 206 ; 208) comprend
un canal fluidique (46, 48 ; 246 ; 248) adapté pour être relié à un moyen d'alimentation de fluide (50, 52) pour alimenter en fluide ledit canal (46, 48 ; 246 ; 248), et
au moins une buse (54 ; 254) reliée audit canal fluidique (46, 48 ; 246 ; 248) et adaptée pour éjecter ledit fluide dans la direction du substrat (26) afin de faciliter le retrait du substrat (26) du dispositif (4) après ladite formation d'un motif.

10. Dispositif selon l'une quelconque des revendications précédentes, dans lequel la région imprimée d'au moins l'une des plaques d'impression (206, 208) est formée sur un moule séparé (210, 212) fixé de manière détachable à au moins l'une des plaques d'impression (206, 208).

11. Procédé destiné à transférer des motifs, en particulier des micro ou nanostructures, à au moins deux faces (22, 24) d'un substrat (26), le procédé comprenant les étapes consistant à
fournir une première région imprimée (16 ; 210 ; 316) sur une première plaque d'impression (6 ; 206 ; 306),
fournir une deuxième région imprimée (18 ; 212 ; 318) sur une deuxième plaque d'impression (8 ; 208 ; 308),
positionner les deux plaques d'impression (6, 8 ; 206, 208 ; 306, 308) de sorte que les régions imprimées (16, 18 ; 210, 212 ; 316, 318) soient en face l'une de l'autre,
fixer les deux plaques d'impression (6, 8 ; 206, 208 ; 306, 308) l'une à l'autre à une position (10, 12) sur celle-ci située à une distance desdites régions imprimées (16, 18; 210, 212 ; 316, 318),
placer un substrat (26) entre les régions imprimées (16, 18 ; 210, 212 ; 316, 318), et
mettre en contact le substrat (26) avec la première région imprimée (16 ; 210 ; 316) et la deuxième région imprimée (18 ; 212 ; 318).

12. Procédé selon la revendication 11, dans lequel l'étape consistant à mettre en contact le substrat (26) avec la première région imprimée (16 ; 210 ; 316) et la deuxième région imprimée (18 ; 212 ; 318) consiste en outre à fournir une pression fluidique sur au moins l'une des plaques d'impression (6, 8 ; 206, 208 ; 306, 308) à la face de ladite plaque d'impression (6, 8 ; 206, 208 ; 306, 308) à l'opposé dudit substrat (26).

13. Procédé selon la revendication 11 ou 12, comprenant en outre l'étape consistant à diriger un écoulement de fluide provenant d'ouvertures (54 ; 254, 256) dans les plaques d'impression (6, 8 ; 206, 208 ; 306, 308) vers le substrat (26) pour faciliter le retrait dudit substrat (26) après le transfert du motif.
